# EUROPÄISCHE PATENTSCHRIFT

(11) **EP 1 472 562 B1**
(45) Veröffentlichungstag und Bekanntmachung des Hinweises auf die Patenterteilung: **14.04.2010**
(21) Anmeldenummer: 02806742.9
(22) Anmeldetag: 23.12.2002
(51) Int. Cl.: G02B 7/182, G02B 5/09

(54) **FACETTENSPIEGEL MIT MEHREREN SPIEGELFACETTEN**
MULTI-FACETED MIRROR
MIROIR A PLUSIEURS FACETTES

(30) Priorität: 09.02.2002 DE 10205425
(43) Veröffentlichungstag der Anmeldung: 03.11.2004
(73) Patentinhaber: Carl Zeiss SMT AG, 73447 Oberkochen (DE)
(72) Erfinder: HOLDERER, Hubert, 89551 Königsbronn (DE); WEISS, Markus, 73434 Aalen (DE); SINGER, Wolfgang, 73431 Aalen (DE); SEIFERT, Andreas, 73434 Aalen (DE); HEISLER, Andreas, 89555 Steinheim (DE); MELZER, Frank, 73469 Utzmemmingen (DE); MANN, Heinz, 73431 Aalen (DE); FALTUS, Jürgen, 73432 Aalen (DE)
(74) Vertreter: Lorenz, Werner
(86) Internationale Anmeldenummer: PCT/EP2002/014748
(87) Internationale Veröffentlichungsnummer: WO 2003/067304

(56) Entgegenhaltungen:
- EP-A- 0 916 984
- WO-A-98/14815
- DE-A- 2 363 765
- PATENT ABSTRACTS OF JAPAN vol. 1995, no. 11, 26. Dezember 1995 (1995-12-26) -& JP 07 199038 A (SUMITOMO HEAVY IND LTD), 4. August 1995 (1995-08-04)
- PATENT ABSTRACTS OF JAPAN vol. 2000, no. 09, 13. Oktober 2000 (2000-10-13) -& JP 2000 167683 A (MITSUBISHI ELECTRIC CORP), 20. Juni 2000 (2000-06-20)
- PATENT ABSTRACTS OF JAPAN vol. 1995, no. 01, 28. Februar 1995 (1995-02-28) -& JP 06 291023 A (NEC CORP), 18. Oktober 1994 (1994-10-18)

## Beschreibung

Die Erfindung betrifft einen Facettenspiegel mit mehreren Spiegelfacetten, welcher in Beleuchtungseinrichtungen für Projektionsbelichtungsanlagen in der Mikrolithographie, insbesondere für in der Mikrolithographie unter Verwendung von Strahlung im Bereich des extremen Ultravioletts, einsetzbar ist. Außerdem beschreibt die Erfindung eine Vorrichtung zur Justage der Spiegelfacetten eines Facettenspiegels, welcher in Beleuchtungseinrichtungen für Projektionsbelichtungsanlagen in der Mikrolithographie, insbesondere in der Mikrolithographie unter Verwendung von Strahlung im Bereich des extremen Ultravioletts, eingesetzt ist.

Kippspiegel als Spiegelfacetten für mehrere dieser Spiegelfacetten umfassenden Facettenspiegeln sind aus dem Stand der Technik bekannt.

So beschreibt beispielsweise die GB 2 255 195 A derartige Facettenspiegel mit einzelnen Kippspiegeln und entsprechenden Lagerelementen für die Facettenspiegel, deren Einsatzzweck insbesondere im Bereich der solaren Energietechnik zu suchen ist.

Jeder einzelne der Kippspiegel ist dabei so ausgebildet, daß er aus einer Spiegelfläche besteht, welche über einen Stab mit einer Kugel verbunden ist, welche in entsprechenden Lagereinrichtungen befestigt ist. Die Genauigkeit von derartigen Anordnungen hinsichtlich der Möglichkeit ihrer Justage oder dergleichen ist dabei äußerst beschränkt, da die Halterung der einzelnen Kippspiegel vergleichsweise lose ist und eine Dejustage sehr leicht und schnell erfolgen kann.

Bei einem derartigen Aufbau lassen sich daher die bei der Justage erforderlichen Genauigkeiten, welche für den Anwendungsfall der oben genannten Erfindung in einer Projektionsbelichtungsanlage für die Mikrolithographie, insbesondere für den Einsatz unter Strahlung im Bereich des extremen Ultravioletts (EUV), erforderlich sind, sicherlich nicht realisieren. Des weiteren kann bei der Justage der Zugriff auf die einzelnen Spiegelfacetten nur von der Seite ihrer Spiegeloberfläche her erfolgen, so daß ein Ausrichten der einzelnen Spiegel unter Beleuchtung vergleichsweise aufwendig und schwierig ist.

Des weiteren ist durch die EP 0 726 479 A2 eine Kippspiegelanordnung beschrieben, welche mindestens einen Kippspiegel, einen Basiskörper und mindestens eine Spiegellagerung mit zumindest nahezu festem Drehpunkt zwischen dem Kippspiegel und der Basis besitzt. Gemäß der Schrift ist bei Spiegelflächen mit einer charakteristischen Länge kleiner als 40 mm, die Baugröße der gesamten Anordnung von Kippspiegellagerung und - gehäuse derart unterhalb der Spiegeloberfläche angeordnet, daß sie in der Projektion Spiegelebene nicht oder bei Auslenkung des Kippspiegels nur unwesentlich über diese hinausragt. Derartige Kippspiegel werden beispielsweise im Bereich der Lasertechnologie eingesetzt.

Durch die Möglichkeit, den Basiskörper über die Spiegellagerung entsprechend zu lagern und gegebenenfalls nachzujustieren, wird bei derartigen Spiegeln die Justage auch unter Beleuchtung möglich. Allerdings ist der Aufbau sehr aufwendig, so daß bei Facettenspiegeln, welche aus diesen Kippspiegeln gebildet werden könnten, ein sehr hoher Aufwand hinsichtlich des Bauraums in axialer Richtung, den Justageelementen, den Kosten und dergleichen zu erwarten ist.

Aus der DE 23 36 765 ist eine Lagerung für einen schwenkbaren Spiegel für kohärentoptische Systeme bekannt. Der Spiegel ist dabei auf der Kreisfläche eines Kugelabschnitts angeordnet, wobei das Zentrum der Kugel auf der Spiegeloberfläche liegt. Der Kugelabschnitt ist in einer Kugelpfanne bzw. -kalotte entsprechenden Durchmessers gelagert. Zur Bewegung und Steuerung ist der Kugelabschnitt mit einem hebelförmigen, radial zur Kugel angeordneten Fortsatz versehen. Dabei ist der Fortsatz mittels einer in einer zur Ebene der Nullstellung des Spiegels parallelen Ebene wirksamen Verstelleinrichtung bewegbar.

Weitere Kippspiegelanordnungen sind aus den Druckschriften EP 0916984 A1, DE 2363765, JP 07199038 und JP 2000167683 bekannt.

Es ist die Aufgabe der Erfindung, die oben genannten Nachteile des Standes der Technik zu vermeiden und einen Facettenspiegel mit mehreren Spiegelfacetten zu schaffen, welcher einen sehr einfachen Aufbau hat, und welcher den sehr hohen Anforderungen hinsichtlich der optischen Qualität und hinsichtlich der Auflösung der Justage der einzelnen Spiegelfacetten, wie sie in der Mikrolithographie, insbesondere in der EUV-Lithographie auftreten, genügen kann.

Erfindungsgemäß wird diese Aufgabe dadurch gelöst, daß jede der Spiegelfacetten einen Kugelkörper aufweist, wobei eine Spiegeloberfläche in einer Ausnehmung des Kugelkörpers angeordnet ist, und wobei die der Spiegeloberfläche abgewandte Seite des Kugelkörpers in einer Lagereinrichtung gelagert ist.

Die Spiegeloberfläche ist einstückig oder auf einem Zwischenelement in den Kugelkörper eingebracht, welcher gleichzeitig als Lagerkörper für die Lagerung der Spiegelfacette in der Lagereinrichtung dient. Somit ist ein Aufbau geschaffen, welcher es erlaubt, daß jede Spiegelfacette frei und unabhängig von den anderen Spiegelfacetten einjustiert werden kann. Der Aufbau aus der einen Kugel als Spiegel- und Lagerkörper ist dabei sehr einfach und kostengünstig.

Außerdem wird die oben genannte Aufgabe durch eine Vorrichtung zur Justage eines derartigen Facettenspiegels für denselben Einsatzzweck gelöst, wobei an jeder der Spiegelfacetten auf der der Spiegeloberfläche abgewandten Seite des Kugelkörpers ein Hebelelement angeordnet ist, und an dem Hebelelement in einem dem Kugelkörper abgewandten Bereich Stellmittel angreifen, durch welche eine Bewegung des Kugelkörpers um seinen Mittelpunkt erzielbar ist.

Durch die Möglichkeit der Justage an dem Hebelelement wird im Bereich der optisch wirksamen Frontseite des Facettenspiegels keinerlei zusätzliche Aktuatorik oder Sensorik notwendig, welche den Belastungen durch die Strahlung ausgesetzt wäre. Jegliche Stellmittel lassen sich im Bereich des Hebelelements auf der der Spiegelfacette abgewandten Seite des Facettenspiegels anordnen. Neben einer reinen Dejustage ermöglichen die Stellmittel, je nach Ausführung auch ein sicheres Halten der Spiegelfacetten in ihrer vorgegebenen Position bzw. in der vorgegebenen Ausrichtung der Oberflächennormalen der Spiegeloberfläche jeder der Spiegelfacetten. Damit läßt sich mit einfachen und platzsparend konstruierbaren Ausgestaltungen ein Aufbau erreichen, welcher die oben genannten Anforderungen voll erfüllt, und welcher darüber hinaus eine hohe Langzeitstabilität und eine hohe Sicherheit gegenüber mechanischer Beeinträchtigung durch Stöße, Schwingungen und dergleichen aufweist, da über die Stellmittel das Hebelelement und damit die Spiegelfacette nicht nur justiert sondern auch festgehalten werden kann.

Weitere vorteilhafte Ausgestaltungen der Erfindung ergeben sich aus den restlichen Unteransprüchen sowie aus den anhand der Zeichnung nachfolgend dargestellten Ausführungsbeispielen.

Es zeigt:
- Figur: 1 eine Prinzipdarstellung einer Projektionsbelich- tungsanlage für die Mikrolithographie, welche zur Belichtung von Strukturen auf mit photosensitiven Materialien beschichtete Wafer verwendbar ist;
- Figur 2: eine Prinzipdarstellung einer Projektionsbelich- tungsanlage für die Mikrolithographie, wie sie bei der Verwendung mit Strahlung im Bereich des extre- men Ultraviolett einsetzbar ist;
- Figur 3: einen möglichen Aufbau eines Facettenspiegels gemäß der Erfindung;
- Figur 4: einen Querschnitt durch einen prinzipmäßigen, mög- lichen alternativen Aufbau eines Facettenspiegels gemäß der Erfindung;
- Figur 5: einen Querschnitt durch eine alternative Ausfüh- rungsform einer Spiegelfacette in einer alternativ ausgebildeten Lagereinrichtung;
- Figur 6: eine Draufsicht auf die Spiegelfacette gemäß Figur 5;
- Figur 7: eine Vorrichtung zur Justage der Lage einer der Spiegelfacetten in einer weiteren alternativ ausge- bildeten Lagereinrichtung;
- Figur 8: eine Ansicht eines Teils der Vorrichtung gemäß Fi- gur 7 von unten;
- Figur 9: einen Teil einer alternativen Ausgestaltung einer Vorrichtung zur Justage der Lage einer der Spiegelfacetten;
- Figur 10: einen Teil einer weiteren alternativen Ausgestal- tung einer Vorrichtung zur Justage der Lage einer der Spiegelfacetten;
- Figur 11: eine Ansicht eines Teils der Vorrichtung gemäß Fi- gur 10 von unten;
- Figur 12: eine zusätzliche alternative Ausgestaltung einer Vorrichtung zur Justage der Lage einer der Spiegelfacetten;
- Figur 13: eine prinzipmäßige Schnittdarstellung gemäß der Li- nie XIII-XIII in Figur 12;
- Figur 14: eine alternative Ausführung eines Details der Aus- gestaltung der Vorrichtung gemäß Figur 12; und
- Figur 15: eine Prinzipdarstellung einer möglichen Einrichtung zur Erhöhung der Reibung der Spiegelfacette in der Lagereinrichtung.

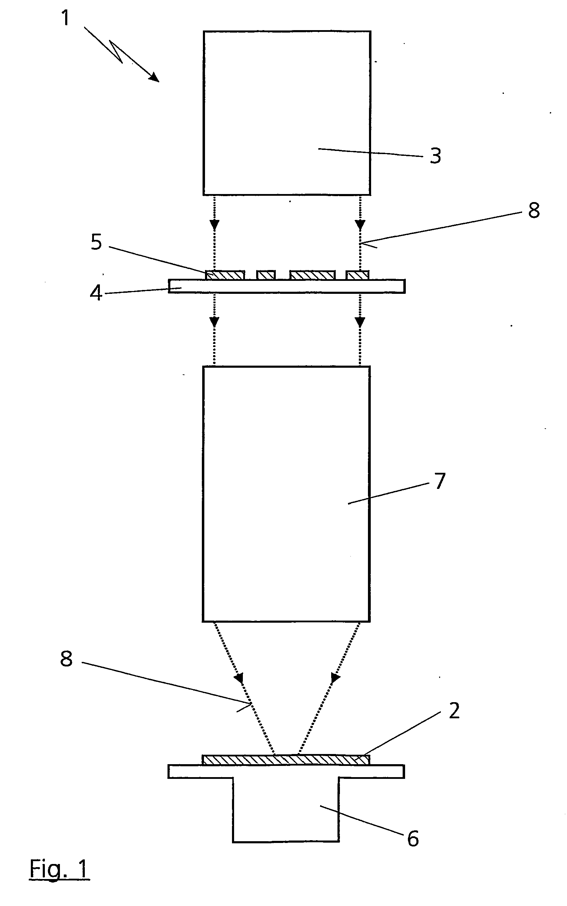

In Figur 1 ist eine Projektionsbelichtungsanlage 1 für die Mikrolithographie dargestellt. Diese dient zur Belichtung von Strukturen auf mit photosensitiven Materialien beschichtetes Substrat, welches im allgemeinen überwiegend aus Silizium besteht und als ein Wafer 2 bezeichnet wird, zur Herstellung von Halbleiterbauelementen, wie z.B. Computerchips.

Die Projektionsbelichtungsanlage 1 besteht dabei im wesentlichen aus einer Beleuchtungseinrichtung 3, einer Einrichtung 4 zur Aufnahme und exakten Positionierung einer mit einer gitterartigen Struktur versehenen Maske, ein sogenanntes Reticle 5, durch welche die späteren Strukturen auf den Wafer 2 bestimmt werden, einer Einrichtung 6 zur Halterung, Fortbewegung und exakten Positionierung eben dieses Wafers 2 und einer Abbildungseinrichtung 7.

Das grundsätzliche Funktionsprinzip sieht dabei vor, daß die in das Reticle 5 eingebrachten Strukturen auf den Wafer 2 belichtet werden, insbesondere mit einer Verkleinerung der Strukturen auf ein Drittel oder weniger der ursprünglichen Größe. Die an die Projektionsbelichtungsanlage 1, insbesondere an die Abbildungseinrichtung 7, zu stellenden Anforderungen hinsichtlich der Auflösungen liegen dabei im Bereich von wenigen Nanometern.

Nach einer erfolgten Belichtung wird der Wafer 2 weiterbewegt, so daß auf demselben Wafer 2 eine Vielzahl von einzelnen Feldern, jeweils mit der durch das Reticle 5 vorgegebenen Struktur, belichtet wird. Wenn die gesamte Fläche des Wafers 2 belichtet ist, wird dieser aus der Projektionsbelichtungsanlage 1 entnommen und einer Mehrzahl chemischer Behandlungsschritte, im allgemeinen einem ätzenden Abtragen von Material, unterzogen. Gegebenenfalls werden mehrere dieser Belichtungs- und Behandlungsschritte nacheinander durchlaufen, bis auf dem Wafer 2 eine Vielzahl von Computerchips entstanden ist. Aufgrund der schrittweisen Vorschubbewegung des Wafers 2 in der Projektionsbelichtungsanlage 1 wird diese häufig auch als Stepper bezeichnet.

Die Beleuchtungseinrichtung 3 stellt eine für die Abbildung des Reticles 5 auf dem Wafer 2 benötigten Projektionsstrahl 8, beispielsweise Licht oder eine ähnliche elektromagnetische Strahlung, bereit. Als Quelle für diese Strahlung kann ein Laser oder dergleichen Verwendung finden. Die Strahlung wird in der Beleuchtungseinrichtung 3 über optische Elemente so geformt, daß der Projektionsstrahl 8 beim Auftreffen auf das Reticle 5 die gewünschten Eigenschaften hinsichtlich Durchmesser, Polarisation, Form der Wellenfront und dergleichen aufweist.

Über den Projektionsstrahl 8 wird eine Bild des Reticles 5 erzeugt und von der Abbildungseinrichtung 7 entsprechend verkleinert auf den Wafer 2 übertragen, wie bereits vorstehend erläutert wurde. Die Abbildungseinrichtung 7, welche auch als Objektiv bezeichnet werden könnte, besteht dabei aus einer Vielzahl von einzelnen refraktiven und/oder diffraktiven optischen Elementen, wie z.B. Linsen, Spiegeln, Prismen, Abschlußplatten und dergleichen.

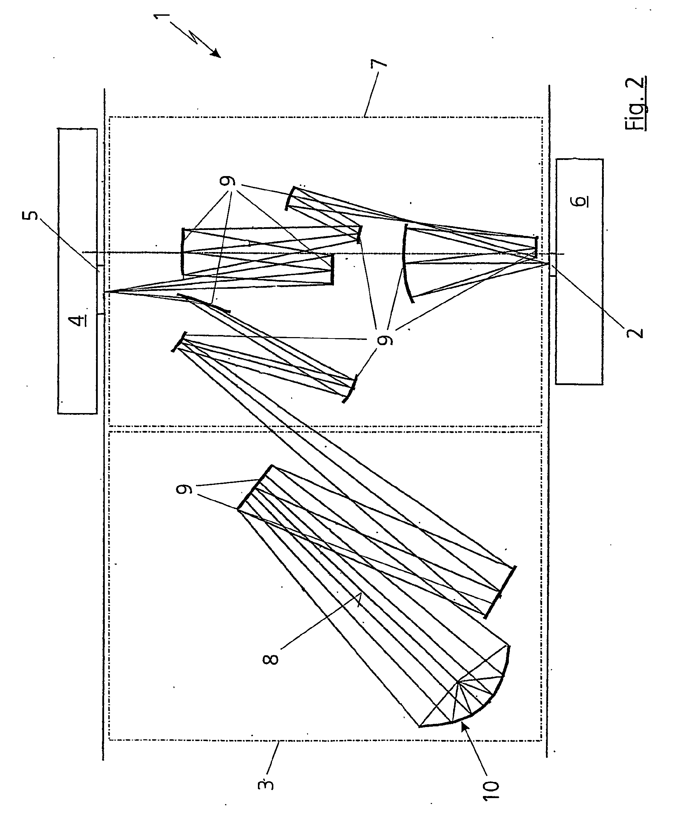

Figur 2 zeigt eine prinzipmäßige Darstellung eines Aufbaus analog zu Figur 1, hier jedoch für die Verwendung mit einem Projektionsstrahl 8, dessen Wellenlänge im Bereich des extremen Ultraviolett (EUV) liegt. Bei diesen Wellenlängen, im allgemeinen ca. 13 nm, ist die Verwendung von refraktiven optischen Elementen nicht mehr möglich, so daß sämtliche Elemente als reflektierende Elemente ausgebildet sein müssen. Dies wird hier durch die zahlreichen Spiegel 9 dargestellt. Mit Ausnahme des Verlaufs des Projektionsstrahls 8 ist die hier dargestellte Projektionsbelichtungsanlage 1, wie sie für die EUV-Lithographie Verwendung finden kann, vergleichbar zu der in Figur 1 bereits beschriebenen Projektionsbelichtungsanlage 1 aufgebaut. Die gleichen Vorrichtungselemente weisen dabei die gleichen Bezugszeichen auf, so daß auf nähere Erläuterungen an dieser Stelle verzichtet werden soll.

Im Bereich der hier durch die strichpunktierte Linie angedeuteten Beleuchtungseinrichtung 3 ist dabei ein Facettenspiegel 10 angeordnet, welcher eine entscheidende Bedeutung für die Qualität und die Homogenität des Projektionsstrahls 8 hat. Die nachfolgenden Erläuterungen beziehen sich auf den Aufbau eines derartigen Facettenspiegels 10, wie er ganz allgemein in der Mikrolithographie, insbesondere jedoch in dem Beleuchtungssystem 3 für die EUV-Lithographie eingesetzt werden kann.

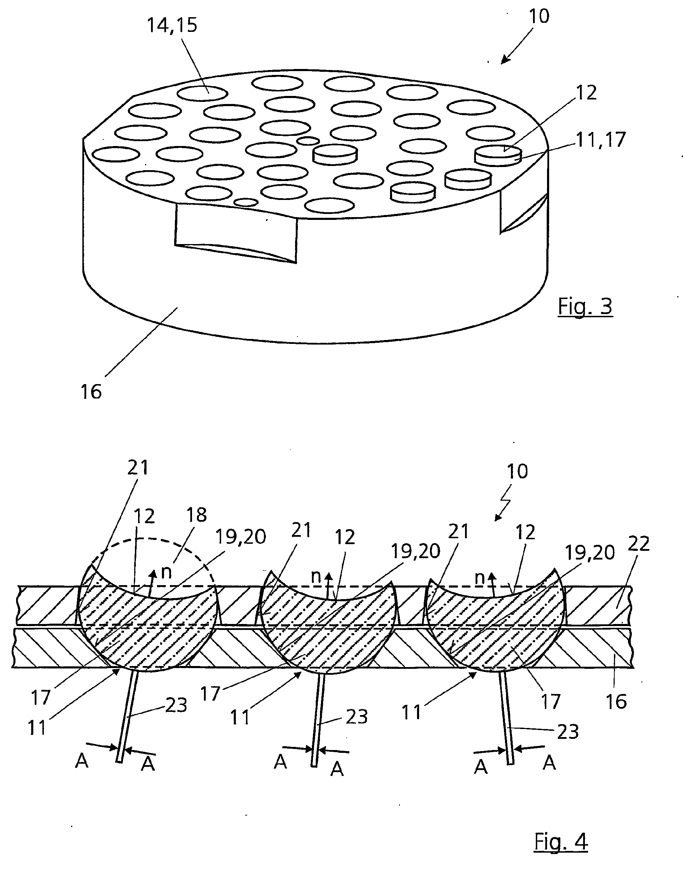

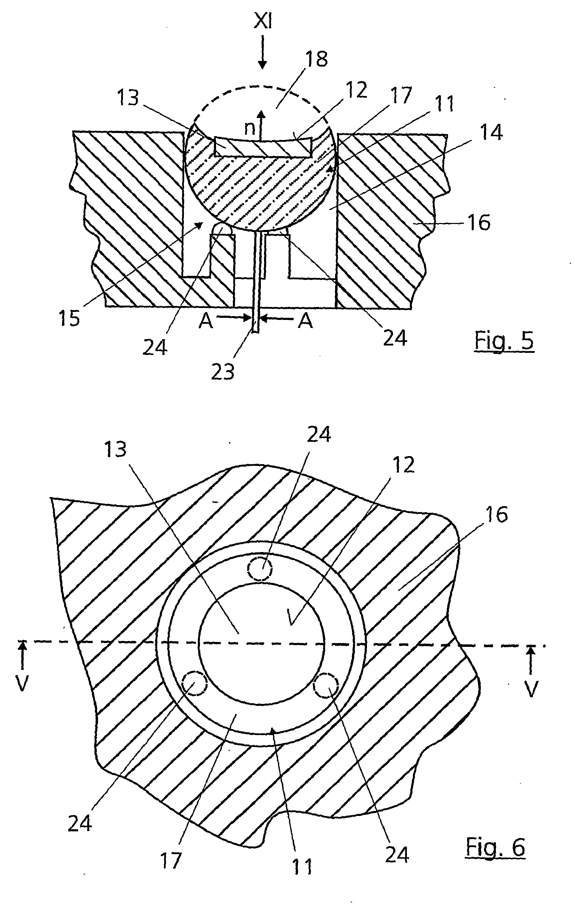

Figur 3 zeigt beispielhaft einen möglichen Aufbau des Facettenspiegels 10 mit einzelnen Spiegelfacetten 11. Jede der Spiegelfacetten 11 weist eine Spiegeloberfläche 12 auf, welche zur Reflexion von Strahlung geeignet ist. Je nach Typ der eingesetzten Strahlung, wie z.B. Licht, UV-Strahlung, Röntgenstrahlung oder dergleichen, kann der Aufbau der Spiegeloberfläche 12 variieren. Denkbar sind hier verschiedene Aufbauten aus zum Teil vielen auf eine Substrat aufgebrachten, z.B. aufgedampften, Multilayer-Schichten. Die Spiegeloberfläche 12 kann dabei direkt auf die Spiegelfacette 11 oder auch auf ein Zwischenelement 13 (hier nicht dargestellt; in Figur 6 erkennbar) aufgebracht werden. Die Verwendung des Zwischenelements 13 ist dabei insbesondere beim Einsatz mit sehr kurzwelliger Strahlung, z.B. der Strahlung im Bereich des extremen Ultravioletts (EUV), sehr günstig, da hier sehr hohe Anforderungen an die Oberflächenqualität der Spiegeloberfläche 12 und damit auch der Oberfläche unter dieser Spiegeloberfläche 12 gestellt werden müssen. Bei der Verwendung des Zwischenelements 13 entfällt dann aber der Aufwand, die gesamte Spiegelfacette 11 aus einem Material zu fertigen, welches eine derart gute Bearbeitung seiner Oberfläche erlaubt, wie die, die für die Reflexion von EUV-Strahlung erforderlich ist.

Zur Bildung des Facettenspiegels 10 sitzt dabei jede einzelne der Spiegelfacetten 11 in einer Aufnahmeöffnung 14 als Lagereinrichtung 15 für die Spiegelfacetten 11. Die Aufnahmeöffnungen 14 sind dabei in einer Trägerplatte 16 angeordnet. Die einzelnen Spiegelfacetten 11, von welchen hier nur einige dargestellt sind, haben zumindest im Bereich ihrer Auflage auf den Lagereinrichtungen 15 die Form eines Kugelkörpers 17, welcher in einer Ausnehmung 18 (hier nicht erkennbar; in Figur 4 dargestellt) die Spiegeloberfläche 12 direkt oder auf dem Zwischenelement 13 trägt.

In Figur 4 ist ein Teil des Facettenspiegels 10 in einer alternativen Ausführungsform dargestellt. Insbesondere die Ausgestaltung der Spiegelfacetten 11 ist hier deutlicher zu erkennen. Der Facettenspiegel 10 weist in dem hier dargestellten Ausschnitt des Ausführungsbeispiels drei der Spiegelfacetten 11 auf. Jede der Spiegelfacetten 11 ist wiederum als Kugelkörper 17 ausgebildet. In jedem der Kugelkörper 17 befindet sich die Ausnehmung 18, welche hier nur an einem der Kugelkörper 17, welcher mit einer gestrichelten Linie auf die Querschnittsform einer Kugel ergänzt wurde, mit einem Bezugszeichen versehen ist. Die verbleibende Fläche des Kugelkörpers 17 im Bereich dieser Ausnehmung 18 bildet dann die Spiegeloberfläche 12, welche in Figur 4 jeweils zusätzlich durch ihre Oberflächennormale n symbolisiert ist. Die Ausgestaltung der Spiegeloberfläche 12 kann je nach Einsatzzweck des Facettenspiegels 10 als sphärische, plane oder asphärische Spiegeloberfläche 12 erfolgen. Für den bevorzugten Einsatzzweck in der EUV-Lithographie wird die Spiegeloberfläche 12 im allgemeinen sphärisch ausgebildet sein, wobei der Radius der Spiegeloberfläche 12 sehr viel größer als der Radius des Kugelkörpers 17 ist.

Jede der Spiegelfacetten 11 ist in der Lagereinrichtung 15 gelagert. Die Lagereinrichtung 15 besteht in dem hier dargestellten Ausführungsbeispiel aus einer konischen Bohrung 19, die in die Trägerplatte 16 eingebracht ist. Der Kugelkörper 17 liegt in dieser konischen Bohrung 19, deren größerer Öffnungsdurchmesser dabei so angeordnet ist, daß der Kugelkörper 17 in der konischen Bohrung 19 liegt, durch diese jedoch nicht hindurchfallen kann. Im Bereich der konischen Bohrung 19 bzw. der Lagereinrichtung 15 kommt es somit zu einer kreisringförmigen Auflagefläche 20 zwischen dem Kugelkörper 17 und der Trägerplatte 16.

Des weiteren weist der Facettenspiegel 10 in dem hier dargestellten Ausführungsbeispiel Einrichtungen zum sicheren Festhalten der Kugelkörper 17 auf. Diese Einrichtungen sind gemäß dem hier dargestellten Ausführungsbeispiel als eine weitere konische Bohrung 21 ausgebildet, welche in eine Halteplatte 22 eingebracht ist. Der größere Öffnungsdurchmesser der weiteren konischen Bohrung 21 ist so angeordnet, daß er der Trägerplatte 16 zugewandt ist.

Für die ideale Funktionsweise ist es nun besonders günstig, wenn an jeder der Spiegelfacetten 11 auf ihrer der Spiegeloberfläche 12 abgewandten Seite eine Justageeinrichtung angebracht ist. Diese Justageeinrichtung kann beispielsweise als ein mit dem Kugelkörper 17 verbundenes Hebelelement 23 ausgebildet sein. Über ein derartiges Hebelelement 23, welches durch die konische Bohrung 19 in der Trägerplatte 16 hindurchragt, kann der Facettenspiegel 10 so von hinten, also von seiner der Beleuchtung abgewandten Seite, unter Beleuchtung, also unter den bestimmungsgemäßen Betrieb vorgesehenen Bedingungen, einjustiert werden. Durch die Länge des Hebelelements 23 kann dabei das Übersetzungsverhältnis zwischen der Bewegung der Spiegeloberfläche 12 bzw. ihrer Oberflächennormalen n und der Auslenkung des Hebelelements 23 eingestellt werden. Besonders sinnvoll ist es dabei, wenn das Hebelelement 23 fluchtend mit der Oberflächennormalen n der Spiegeloberfläche 12 ausgebildet ist, so daß die Bewegungsrichtungen der Oberflächennormalen n und des Hebelelements 23 entgegengesetzt parallel verlaufen. Eine sehr einfache und leicht zu verstehende Einstellbarkeit ist damit gewährleistet. Die dabei erreichte Stellgenauigkeit für die Kippwinkel der Spiegelfacetten liegt im Sekundenbereich.

Sehr günstig ist es dann, wenn über entsprechende Kräfte auf der dem Kugelkörper 17 abgewandten Seite des Hebelelements 23 eine Justage der Lage der Spiegeloberfläche 12 erfolgt. Diese Kräfte können beispielsweise. über Aktuatoren, welche hier durch die Pfeile A prinzipmäßig angedeutet sind, auf das Hebelelement 23 aufgebracht werden. Als Aktuatoren sind dabei alle bekannten Formen von Aktuatoren bzw. aktiven oder passiven Stellmitteln, welche beispielsweise pneumatische, hydraulische, piezoelektrische, magnetische oder mechanische Kräfte nutzen, denkbar.

Bei der Montage und Justage eines derartigen Facettenspiegels 10 wird nun so vorgegangen, daß die Spiegelfacetten 11 in die konischen Bohrungen 19 der Trägerplatte 16 eingelegt werden. Danach wird die Halteplatte 22 mit ihren konischen Bohrungen 21 über den Spiegelfacetten 11 positioniert und abgesenkt. Die beiden Platten 16, 22 liegen dann lose aufeinander, so daß die Spiegelfacetten 11 über die Hebelelemente 23 hinsichtlich der Ausrichtung der Oberflächennormalen n der Spiegeloberfläche 12 noch verändert werden können. Unter Beleuchtung des gesamten Facettenspiegels 10 wird dann die Justage jeder einzelnen Spiegeloberfläche 12 des Facettenspiegels 10 über entsprechende Krafteinwirkungen auf das Hebelelement 23 durchgeführt. Sobald die Lage aller Spiegelfacetten 11 in der gewünschten Art und Weise einjustiert ist, wird durch ein Gegeneinanderdrücken der ersten und der zweiten Platte 16, 22 diese Lage fixiert. Besonders günstig ist es dabei, wenn die Trägerplatte 16 aus einem Material ausgebildet ist, welches deutlich weicher als das Material der Kugelkörper 17 ist. Beispielsweise wäre hier eine Materialkombination aus einem keramischen oder kristallinen Material für die Kugelkörper 17 und einem weichen Metall, wie Messing, Kupfer oder Aluminium, für die Trägerplatte 16 denkbar. Im Vergleich dazu sollte die Halteplatte 22 aus einem Material bestehen, welches etwas härter als das Material der Trägerplatte 16 ist, welches jedoch auch deutlich weicher als das Material der Kugelkörper 17 ausgebildet ist. So wird beim Zusammendrücken der beiden Platten 16, 22 sichergestellt, daß die Kugelkörper 17 leicht in die Trägerplatte 16 eingedrückt werden, und daß durch Reibungskräfte dann die Fixierung ihrer Position (auch bei Vibrationen, Schock oder dergleichen) sichergestellt ist.

Sollte die endgültige Position der Spiegelfacette 11 bzw. die Ausrichtung ihrer Oberflächennormalen n beim Zusammenpressen der Platten 16, 22, welches beispielsweise durch ein Verschrauben der beiden Platten 16, 23 miteinander erfolgen kann, eine Dejustage erfahren haben, so kann durch ein Lösen dieser Verschraubung und durch ein Auseinanderdrücken der beiden Platten 16, 22, z.B. durch dazwischen eingebrachte Druckluft, ein Zustand erreicht werden, in dem die Reibung zwischen der Trägerplatte 16 und den Kugelkörpern 17 so weit verringert wird, daß eine erneute Justage möglich ist, ehe die beiden Platten 16, 22 dann nach der erfolgten Justage wieder gegeneinander gedrückt bzw. miteinander verschraubt werden.

Zur Sicherung der endgültig eingestellten Position der einzelnen Spiegelfacetten könnten diese auch zusätzlich noch mit zumindest einer der Platten 16, 22 verklebt oder verlötet werden.

In Figur 5 ist eine alternative Ausführungsform der Spiegelfacette 11 sowohl hinsichtlich der Spiegelfacette 11 selbst als auch hinsichtlich der Lagereinrichtungen 15 dargestellt. Die Spiegelfacette 11 besteht auch hier wieder aus dem Kugelkörper 17 und ist mit dem Hebelelement 23 zur Justage versehen. Im Gegensatz zu den bisher dargestellten Spiegelfacetten 11 ist hier jedoch das oben bereits erwähnte Zwischenelement 13 zu erkennen, welches die Spiegeloberfläche 12 trägt, und welches in die Ausnehmung 18 des Kugelkörpers 17 eingebracht ist. Das Zwischenelement 13, welches im allgemeinen aus einem Spiegelsubstrat bestehen wird, kann dabei über herkömmliche Verfahren in den Bereich der Ausnehmung 18 in dem Kugelkörper 17 eingebracht werden. Besonders sinnvoll wären sicherlich solche Verfahren, wie Ansprengen, Verkleben oder Verlöten, so daß von der Spiegeloberfläche 12 nicht reflektierte und im Bereich des Zwischenelements 13 absorbierte Strahlung, welche sich in Wärme umwandelt, ideal an den Kugelkörper 17 abgeführt werden kann. Dadurch wird eine Beeinträchtigung der Form der Spiegeloberfläche 12 durch thermische Spannungen und dergleichen minimiert.

Der Kugelkörper 17 der Spiegelfacette 11 liegt in dem in Figur 5 dargestellten Ausführüngsbeispiel nun auf einer Lagereinrichtung 15 auf, mit welcher der Kugelkörper 17 einen wenigstens annähernd punktförmigen Kontakt im Bereich von drei Lagerelementen 24, welche beispielsweise als Kugeln ausgebildet sein können, ausbildet.

In Figur 6 ist gemäß einer Draufsicht dieselbe Spiegelfacette 11 nochmals dargestellt. Hier ist deutlich zu erkennen, daß die drei Auflagekörper 24 als echte Dreipunktlagerung ausgebildet und in einem Winkel von jeweils 120° zueinander angeordnet sind. Die besonders günstigen Eigenschaften derartiger Dreipunktlagerungen sind dabei an sich bekannt und werden bei der durch die Figuren 5 und 6 dargestellten Ausführungsform analog zu bekannten derartigen Lagereinrichtungen 15 genutzt.

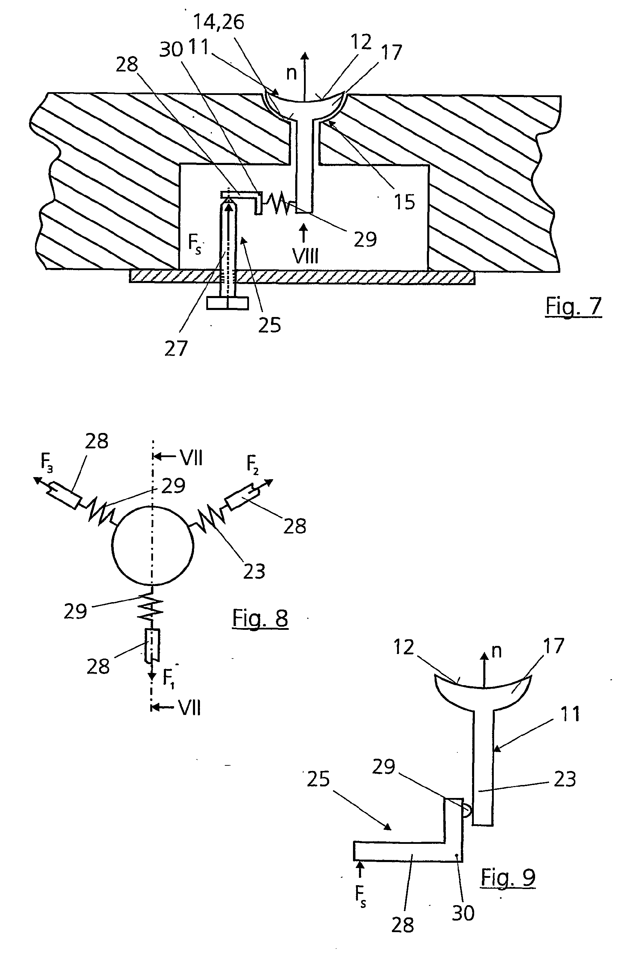

In der Figur 7 ist eine Vorrichtung 25 zur Justage der Lage einer der Spiegelfacetten 11 in der Trägerplatte 16 dargestellt. Außerdem ist in der Figur 7 eine weitere Ausführungsform der Lagereinrichtungen 15 zu erkennen. Die Aufnahmeöffnung 14 ist in dem hier dargestellten Ausführungsbeispiel als Kugelkalotte 26 ausgebildet, welche in ihrem Durchmesser dem Durchmesser des Kugelkörpers 17 der Spiegelfacette 11 entspricht.

Des weiteren sind die bisher nur über die Pfeile A prinzipmäßig angedeuteten Aktuatoren in den nun folgenden Ausführungsbeispielen als die konkreten Stellmittel 27 dargestellt. Die Vorrichtung 25 umfaßt gemäß dem Ausführungsbeispiel der Figur 7 und 8 eines der, hier als Schraube ausgebildetes Stellmittel 27, ein als Hebel 28 ausgebildetes Getriebeelement sowie ein Federmittel 29. Dieser soeben beschriebene Aufbau aus Stellmittel 27, Hebel 28 und Federmittel 29 ist dabei gemäß dem hier dargestellten Ausführungsbeispiel dreifach vorhanden, wie dies in der Ansicht gemäß Figur 8 zu erkennen ist.

In Figur 7 ist die Kraftwirkung des Stellmittels über den Kraftpfeil Fₛ dargestellt. Diese Stellkraft s wirkt auf den Hebel 28; in dem hier dargestellten Ausführungsbeispiel auf den längeren Arm des Hebels 28. Der Hebel 28 kann sich dabei um einen Drehpunkt 30, welcher gegenüber der Trägerplatte 16 feststehend ist, drehen. Der kürzere Schenkel des Hebels 28, welcher mit dem Federmittel 29 verbunden ist wird daraufhin eine Bewegung ausführen, welche das-Federmittel spannt, so daß sich das Hebelelement 23 der Spiegelfacette 11 in Richtung des Hebels 28 bewegt. Die Spiegelfacette 11 wird also ausgelenkt.

Dieser Aufbau ist in Figur 8 nochmals besser zu erkennen. Hier sind die jeweiligen Kräfte F₁, F₂ und F₃ eingezeichnet welche sich aufgrund einer wie in dem Ausführungsbeispiel gemäß Figur 7 angreifenden Stellkraft Fₛ einstellen werden. Durch die Betätigung der Stellmittel 27, welche ebenfalls dreimal vorhanden sind, kann dann die exakte Position der Spiegelfacette 11 hinsichtlich der Ausrichtung der Oberflächennormalen n der Spiegeloberfläche 12 erreicht werden.

In Figur 9 ist in einer stark vereinfachten und schematisierten Darstellung ein weiteres Funktionsprinzip einer alternativen Ausführungsform der Vorrichtung 25 zu erkennen. Auch hier ist ein Hebel 28 vorhanden, welcher sich um einen gegenüber der nicht dargestellten Trägerplatte 16 festen Drehpunkt 30 drehen kann. Der Hebel 28 wird wiederum durch ein an sich beliebiges Stellmittel 27, welches hier lediglich durch die Stellkraft Fₛ angedeutet ist betätigt. Der Hebel dreht sich, wie bereits erwähnt, um den Drehpunkt 30 und rückt mit einem in dem hier dargestellten Ausführungsbeispiel als Druckfedermittel realisierten Federmittel 29 gegen das Hebelelement 23 des Facettenspiegels 11. Durch den Aufbau kann dabei eine vergleichbare Justagemöglichkeit erzielt werden, wie dies oben bei der Beschreibung der Figuren 7 und 8 bereits dargestellt wurde.

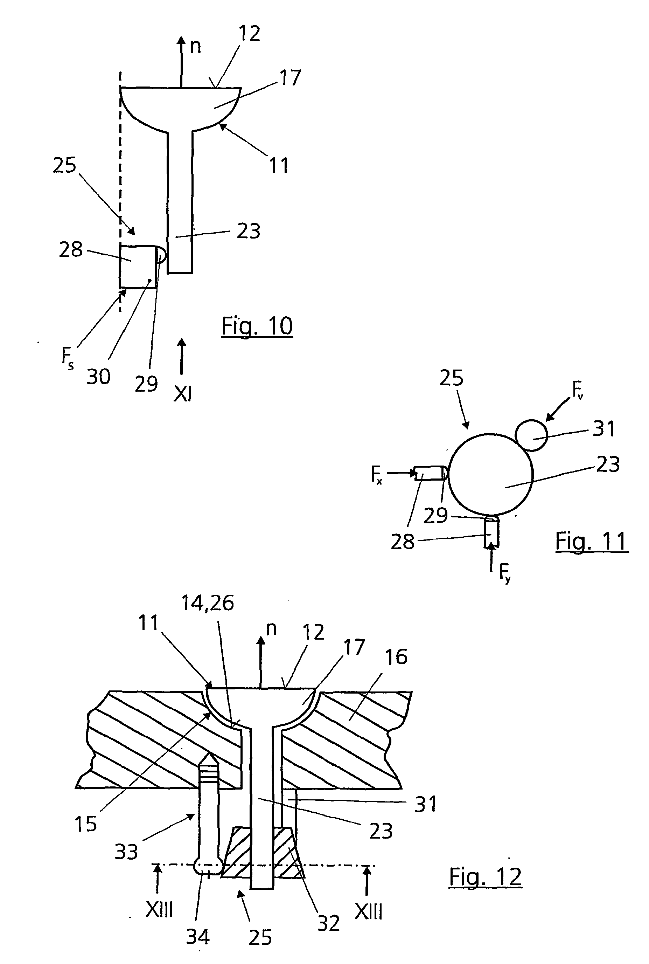

In Figur 10 ist eine weitere alternative Ausführungsform des Aufbaus gemäß Figur 9 dargestellt, wobei hier zusätzlich auf eine Miniaturisierung der gesamten Vorrichtung 25 geachtet wurde. Auch hier ist der Aufbau den oben beschriebenen Ausführungsformen vergleichbar, wobei die Ausführung des Hebels 28 als rechteckiger Block realisiert ist. Dieser rechteckige Block, welcher den Hebel 28 darstellt, läßt sich dabei so klein ausbilden, daß er unter die Projektionsfläche des größten Durchmessers der Spiegelfacette 11 paßt, die Vorrichtung 25 also einen extrem kleinen Bauraum benötigt.

Der Aufbau gemäß Figur 10 gehorcht dabei demselben Funktionsprinzip, wie der oben bereits beschriebene Aufbau gemäß Figur 9, da auch dieser über ein als Druckfedermittel ausgebildetes Federmittel 29 verfügt.

Prinzipiell ist es jedoch denkbar, daß beim Einsatz eines derartigen Aufbaus, wie er in Figur 9 und 10 dargestellt ist, mit lediglich zwei Stellmitteln bzw. Stellkräften Fₛ auszukommen ist. Figur 11 zeigt einen derartigen Aufbau. In der Ansicht gemäß dem Pfeil XI in Figur 10 sind in Figur 11 wieder die beiden Hebel 28 zu erkennen. Da die Kraftwirkung der Stellkraft Fₛ senkrecht auf der Zeichenebene steht, werden hier die daraus resultierenden Kräfte F_{X} und F_{Y}, welche durch den Hebel 28 auf das Hebelelement 23 ausgeübt werden, dargestellt. Die Wirkungen dieser beiden Kräfte stehen aufgrund der Ausrichtung der Hebel 28 in einem Winkel von 90° zueinander, so daß mit dem einen Stellmittel 27 (hier nicht dargestellt) eine Bewegung des Hebelelements 23 in x-Richtung (F_{X}) und mit dem anderen der Stellmittel 27 (hier nicht dargestellt) eine Bewegung des Hebelelements 23 in y-Richtung (F_{Y}) realisiert werden kann.

Auf das Druckfedermittel 29 könnte dabei bei dem hier dargestellten Aufbau auch verzichtet werden, so daß es auch denkbar wäre, daß anstatt des Hebels 28 in Richtung der dargestellten Kräfte F_{X} und F_{Y} mit eigenen Stellmitteln angegriffen werden könnte. In einem Winkel von jeweils 135° zu den Kräften F_{X} und F_{Y} befindet sich bei dem hier dargestellten Ausführungsbeispiel ein Federmittel 31, welches eine Kraftwirkung Fᵥ in Richtung des Mittelpunkts des Hebelelements 23 ausübt. Bei diesem Federmittel 31 könnte es sich beispielsweise um eine Stabfeder handeln, welche in einem leichten Winkel gegen die Parallele zu dem Hebelelement 23 gekippt verläuft, und welche das Hebelelement 23 so gegen die beiden Hebel 28 drückt. Bei einen derartigen Aufbau aus den als Stellkräfte dienenden Kräften F_{X} und F_{Y} und der Vorspannkraft Fᵥ durch das Federmittel 31 entsteht ein Aufbau, bei welchem die Stellmittel 27 eine Verstellung des Hebelelements 23 direkt in kartesischen Koordinaten erlauben.

In Figur 12 ist eine weitere alternative Ausführungsform der Vorrichtung 25 dargestellt. Bei diesem Aufbau der Vorrichtung 25 ist das der Spiegeloberfläche 12 abgewandte Ende des Hebelelements 23 mit einem Konus 32 versehen, welcher sich in dem hier dargestellten Fall in Richtung der Spiegeloberfläche 12 verjüngt. Parallel zu dem Hebelelement 23 des Facettenspiegels 11 verläuft hier eine Stellschraube 33 welche im Bereich ihres Schraubenkopfes 34 ballig ausgestaltet ist. Die ballige Fläche des Schraubenkopfes 34 steht dabei in Kontakt mit dem Konus 32, welcher auf dem Hebelelement 23 des Facettenspiegels 11 angeordnet ist. Durch ein Verstellen der Stellschraube 33 wandert die Anlagefläche zwischen dem balligen Schraubenkopf 34 und dem Konus 32 an dem Konus entlang in Richtung der Spiegeloberfläche 12 oder in die entgegengesetzte Richtung.

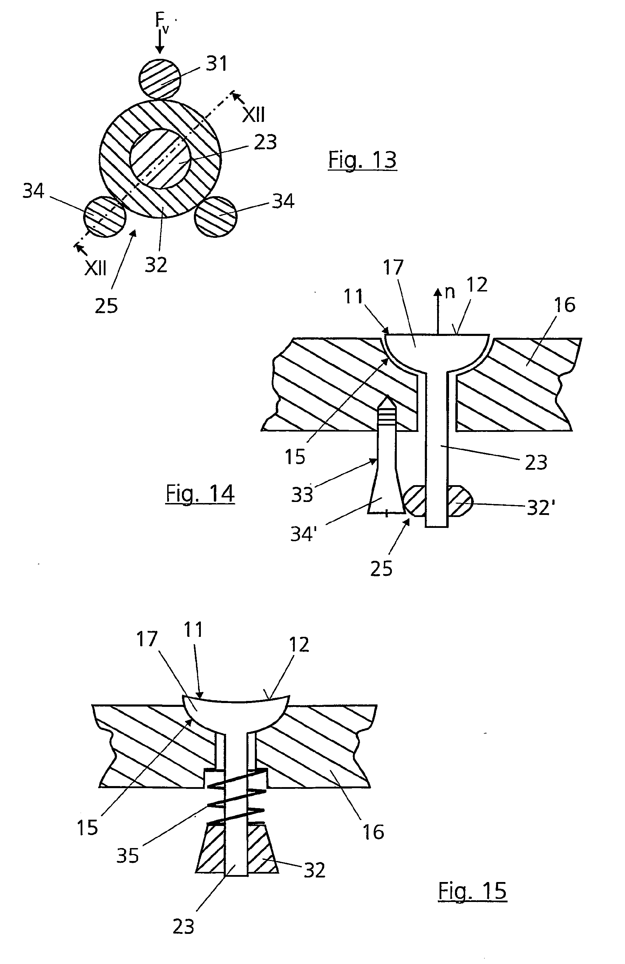

Um mit möglichst wenig Bauteilen auszukommen wird zum Einstellen der Position der Spiegelfacette 11 bzw. der Oberflächennormalen n ihrer Spiegeloberfläche 12 ein Aufbau gewählt, welcher prinzipiell dem in Figur 11 gezeigten Aufbau entspricht. Dieser ist in der Figur 13 angedeutet und weist zwei der Stellschrauben 33 auf. Diesen Stellschrauben 33 ist dann ein entsprechendes Federmittel 31 zur Erzeugung einer Vorspannkraft Fᵥ auf das Hebelelement 23 entgegengesetzt. Die Wirkungsweise und die Anordnung ist vergleichbar zu der Wirkungsweise in Figur 11. Mit einem minimalen Aufwand an Bauteilen läßt sich so eine direkte Einstellung in kartesischen Koordinaten bewirken.

Es ist dabei unerheblich inwieweit die Schraube 33 den balligen Schraubenkopf 34 trägt und der Konus 32 an dem Hebelelement 23 angebracht ist. Es wäre durchaus auch denkbar dies umzukehren, so daß an dem Hebelelement 23 eine ballig ausgebildete Fläche 32' auf eine korrespondierende konische Fläche 34' im Bereich der Stellschraube 33 trifft, wie dies in Figur 14 prinzipmäßig angedeutet ist. Auch die Ausrichtung des Konus 32 bzw. 34', also die Tatsache, daß sich dieser in Richtung der Spiegeloberfläche 12 verjüngt oder verbreitert spielt für die Funktionsweise prinzipiell keine Rolle.

Der Aufbau gemäß den Figuren 12, 13 und 14 ist dabei ebenso wie der Aufbau gemäß Figur 10 extrem platzsparend, so daß die einzelnen Spiegelfacetten 11 in dem Facettenspiegel 10 trotz freier Justierbarkeit Ihrer Oberflächennormalen n sehr direkt plaziert werden können.

In Figur 15 ist nun eine prinzipmäßig angegebene Möglichkeit dargestellt, mittels welcher dafür gesorgt werden kann, daß die zwischen dem Kugelkörper 17 und der Lagereinrichtung 15, in den zuletzt dargestellten Ausführungsbeispielen jeweils der Kugelkalotte 26 eine etwas höhere Reibung einstellt, so daß die einmal eingestellte Position jeder der Spiegelfacetten 11 sicher gehalten wird. In dem hier dargestellten Ausführungsbeispiel ist als derartige Einrichtung zum Festhalten der Spiegelfacette 11 ein Federmittel 35 zwischen dem Konus 32 und der Trägerplatte 16 angebracht. Durch dieses Federmittel 35, welches hier als Druckfedermittel ausgebildet ist, wird der Konus 32 und damit das mit ihm verbundene Hebelelement 23 mit einer Kraft beaufschlagt, so daß sich der Kugelkörper 17 fest gegen die Kugelkalotte 26 preßt und die zwischen diesen beiden Elementen auftretende Reibung entsprechend erhöht wird. Die Spiegelfacette 11 wird so auch bei Schwingungen und/oder Stößen sicher in ihrer Position gehalten.

## Patentansprüche

1. Facettenspiegel (10) mit mehreren Spiegelfacetten (11), welcher in Beleuchtungseinrichtungen (3) für Projektionsbelichtungsanlagen (1) in der Mikrolithographie, insbesondere in der Mikrolithographie unter Verwendung von Strahlung im Bereich des extremen Ultraviolettes, eingesetzt ist, wobei wenigstens ein Teil der Spiegelfacetten (11) jeweils einen Kugelkörper (17) aufweist, wobei eine Spiegeloberfläche (12) in einer Ausnehmung (18) des Kugelkörpers (17) angeordnet ist, und wobei die der Spiegeloberfläche (12) abgewandte Seite des Kugelkörpers (17) in einer Lagereinrichtung (15) gelagert ist, und wobei an wenigstens einem Teil der Spiegelfacetten (11) auf der der Spiegeloberfläche (12) abgewandten Seite des Kugelkörpers (17) ein Hebelelement (23) angeordnet ist, wobei an dem Hebelelement (23) in einem dem Kugelkörper (17) abgewandten Bereich Stellmittel (A,27) angreifen, durch welche eine Bewegung des Kugelkörpers (17) um seinem Mittelpunkt erzielbar ist, und wobei die Stellmittel (27) über als Hebel (28) ausgebildete Getriebeelemente an dem Hebelelement (23) angreifen und wobei die Getriebeelemente (Hebel 28) so klein ausgebildet sind, dass sie unter die Projektionsfläche des größten Durchmessers der Spiegelfacetten (11) passen.

2. Facettenspiegel nach Anspruch 1, **dadurch gekennzeichnet, dass** das Hebelelement (23) und der Kugelkörper (17) einstückig ausgebildet sind.

3. Facettenspiegel nach Anspruch 1 oder 2, **dadurch gekennzeichnet, dass** das Hebelelement (23) mit der Oberflächennormalen (n) der Spiegeloberfläche (12) fluchtend ausgebildet ist.

4. Facettenspiegel nach einem der Ansprüche 1 bis 3, **dadurch gekennzeichnet, dass** die Spiegeloberfläche (12) direkt in die Ausnehmung des Kugelkörpers (17) eingebracht ist.

5. Facettenspiegel nach einem der Ansprüche 1 bis 3, **dadurch gekennzeichnet, dass** die Spiegeloberfläche (12) auf einem Zwischenelement (13) aus Substrat aufgebracht ist, welches in die Ausnehmung (18) des Kugelkörpers (17) eingesetzt und mit diesem verbunden ist.

6. Facettenspiegel nach Anspruch 5, **dadurch gekennzeichnet, dass** das Zwischenelement (13) in der Ausnehmung (18) des Kugelkörpers (17) an den Kugelkörper (17) angesprengt ist.

7. Facettenspiegel nach einem der Ansprüche 1 bis 6, **dadurch gekennzeichnet, dass** die Lagereinrichtung (15) als im Durchmesser mit dem Durchmesser des Kugelkörpers (17) korrespondierende Kugelkalotte (26) ausgebildet ist.

8. Facettenspiegel nach einem der Ansprüche 1 bis 6, **dadurch gekennzeichnet, dass** die Lagereinrichtung so ausgebildet ist, dass der Kugelkörper (17) mit der Lagereinrichtung (15) eine wenigstens annähernd ringförmige Auflagefläche (20) ausbildet.

9. Facettenspiegel nach Anspruch 8, **dadurch gekennzeichnet, dass** die Lagereinrichtung (15) als konische sich in Richtung der Spiegeloberfläche (12) öffnende Bohrung (19) in einer Trägerplatte (16) ausgebildet ist.

10. Facettenspiegel nach einem der Ansprüche 1 bis 6, **dadurch gekennzeichnet, dass** die Lagereinrichtung so ausgebildet ist, dass der Kugelkörper (17) mit der Lagereinrichtung (15) genau drei wenigstens annähernd punktförmige Auflageflächen (Auflageelemente 24) ausbildet.

11. Facettenspiegel nach einem der Ansprüche 1 bis 10, **dadurch gekennzeichnet, dass** jeder der Kugelkörper über Federmittel mit einer Kraft in Richtung gegen die Lagereinrichtung beaufschlagt ist.

12. Vorrichtung (15) zur Justage der Spiegelfacetten (11) eines Facettenspiegels (10), welcher in Beleuchtungseinrichtungen (3) für Projektionsbelichtungsanlagen (1) in der Mikrolithographie, insbesondere in der Mikrolithographie unter Verwendung von Strahlung im Bereich des extremen Ultravioletts, eingesetzt ist, wobei jede der Spiegelfacetten (11) aus einem Kugelkörper (17) besteht, wobei eine Spiegeloberfläche (12) in einer Ausnehmung (18) des Kugelkörpers (17) angeordnet ist, wobei die der Spiegeloberfläche (12) abgewandte Seite des Kugelkörpers (17) in einer Lagereinrichtung (15) gelagert ist, wobei an jeder der Spiegelfacetten (11) auf der der Spiegeloberfläche (12) abgewandten Seite des Kugelkörpers (17) ein Hebelelement (23) angeordnet ist, und wobei an dem Hebelelement (23) in einem dem Kugelkörper (17) abgewandten Bereich Stellmittel (A,27) angreifen, durch welche eine Bewegung des Kugelkörpers (17) um seinem Mittelpunkt erzielbar ist, und wobei die Stellmittel (27) über als Hebel (28) ausgebildete Getriebeelemente an dem Hebelelement (23) angreifen und wobei die Getriebeelemente (Hebel 28) so klein ausgebildet sind, dass sie unter die Projektionsfläche des größten Durchmessers der Spiegelfacetten (11) passen. 2.

13. Vorrichtung nach Anspruch 12, **dadurch gekennzeichnet, dass** die Getriebeelemente als Hebel (28) ausgebildet sind.

14. Vorrichtung nach Anspruch 12, 13 oder 14, **dadurch gekennzeichnet, dass** die Stellmittel (27) über Federmittel (29) an dem Hebelelement (23) angreifen.

15. Vorrichtung nach Anspruch 14, **dadurch gekennzeichnet, dass** drei Stellmittel (27) so an dem Hebelelement (23) angreifen, dass ihre Kraftwirkungen (F₁, F₂, F₃) in einem Winkel von jeweils 120° zueinander und wenigstens annähernd senkrecht zu einer Längsachse des (in einer Neutralstellung befindlichen) Hebelelements (23) stehen.

16. Vorrichtung nach einem der Ansprüche 12 bis 14, **dadurch gekennzeichnet, dass** zwei Stellmittel (27) so an dem Hebelelement (23) angreifen, dass ihre Kraftwirkungen (F_{X}, F_{Y}) in einem Winkel von 90° zueinander und wenigstens annähernd senkrecht zu einer Längsachse des (in einer Neutralstellung befindlichen) Hebelelements (23) stehen, wobei das Hebelelement (23) durch ein Federmittel (31) in einem Winkel von jeweils 135° zu den Kraftwirkungen (F_{X}, F_{Y}), gegen deren Angriffspunkte gedrückt ist.

17. Vorrichtung nach einem der Ansprüche 12 bis 16, **dadurch gekennzeichnet, dass** die Stellmittel (A,27) als Stellschrauben ausgebildet sind.

18. Vorrichtung nach einem der Ansprüche 12 bis 16, **dadurch gekennzeichnet, dass** die Stellmittel (A,27) als Aktuatoren ausgebildet sind.

19. Vorrichtung nach einem der Ansprüche 12 bis 16, **dadurch gekennzeichnet, dass** die Stellmittel in einer Richtung wenigstens annähernd parallel zu dem in Grundstellung ausgerichteten Hebelelement (23) bewegbar sind, und über einen Kontakt zwischen einer balligen Fläche und einer konischen Fläche an dem Hebelelement (23) angreifen.

20. Vorrichtung nach Anspruch 19, **dadurch gekennzeichnet, dass** die Stellmittel als Stellschrauben (33) ausgebildet sind, welche in dem Bereich, in dem sie mit dem Hebelelement (23) in Kontakt stehen ballig ausgebildet sind, wobei das Hebelelement(23) im Kontaktbereich einen sich in Richtung des Spiegels verjüngenden Konus (32) aufweist.

21. Vorrichtung nach Anspruch 19, **dadurch gekennzeichnet, dass** die Stellmittel als Stellschrauben (33) ausgebildet sind, welche in dem Bereich, in dem sie mit dem Hebelelement (23) in Kontakt stehen einen sich jeweils in Richtung des Spiegels verjüngenden Konus (34') aufweisen, wobei das Hebelelement (23) im Kontaktbereich ballig ausgebildet ist.

## Claims

1. Facet mirror (10) having a number of mirror facets (11), which is used in illuminating devices (3) for projection exposure machines (1) in microlithography, in particular in microlithography when employing radiation in the region of the extreme ultraviolet, at least a portion of the mirror facets (11) in each case having a spherical body (17), a reflecting surface (12) being arranged in a recess (18) of the spherical body (17), and the side of the spherical body (17) averted from the reflecting surface (12) being mounted in a bearing device (15), and a lever element (23) being arranged at at least a portion of the mirror facets (11) on the side of the spherical body (17) averted from the reflecting surface (12), control means (A, 27) acting on the lever element (23) in a region averted from the spherical body (17) and making it possible to achieve a movement of the spherical body (17) about its center point, and the control means (27) acting on the lever element (23) via transmission elements constructed as levers (28) and the transmission elements (levers 28) being constructed to be so small that they fit under the projection surface of the largest diameter of the mirror facets (11).

2. The facet mirror as claimed in claim 1, **characterized in that** the lever element (23) and the spherical body (17) are constructed in one piece.

3. The facet mirror as claimed in claim 1 or 2, **characterized in that** the lever element (23) is constructed aligned with the surface normal (n) of the reflecting surface (12).

4. The facet mirror as claimed in one of claims 1 to 3, **characterized in that** the reflecting surface (12) is fixed directly into the recess in the spherical body (17).

5. The facet mirror as claimed in one of claims 1 to 3, **characterized in that** the reflecting surface (12) is applied to an intermediate element (13), from substrate, that is inserted into the recess (18) of the spherical body (17) and connected to the latter.

6. The facet mirror as claimed in claim 5, **characterized in that** the intermediate element (13) in the recess (18) of the spherical body (17) is wrung onto the spherical body (17).

7. The facet mirror as claimed in one of claims 1 to 6, **characterized in that** the bearing device (15) is constructed as a spherical cap (26) that corresponds in diameter to the diameter of the spherical body (17).

8. The facet mirror as claimed in one of claims 1 to 6, **characterized in that** the bearing device is constructed such that the spherical body (17) forms with the bearing device (15) an at least approximately annular sealing surface (20).

9. The facet mirror as claimed in claim 8, **characterized in that** the bearing device (15) is constructed as a conical bore (19) opening in the direction of the reflecting surface (12) in a carrier plate (16).

10. The facet mirror as claimed in one of claims 1 to 6, **characterized in that** the bearing device is constructed such that the spherical body (17) forms with the bearing device (15) precisely three at least approximately punctiform seating surfaces (seating elements 24).

11. The facet mirror as claimed in one of claims 1 to 10, **characterized in that** a force is applied to each of the spherical bodies (17) in the direction of the bearing device via spring means.

12. Device (15) for adjusting the mirror facets (11) of a facet mirror (10), which is used in illuminating devices (3) for projection exposure machines (1) in microlithography, in particular in microlithography when employing radiation in the region of the extreme ultraviolet, each of the mirror facets (11) comprising a spherical body (17), a reflecting surface (12) being arranged in a recess (18) in the spherical body (17), the side of the spherical body (17) averted from the reflecting surface (12) being mounted in a bearing device (15), a lever element (23) being arranged at each of the mirror facets (11) on the side of the spherical body (17) averted from the reflecting surface (12), and control means (A, 27) acting on the lever element (23) in a region averted from the spherical body (17) and making it possible to achieve a movement of the spherical body (17) about its center point, and the control means (27) acting on the lever element (23) via transmission elements constructed as levers (28) and the transmission elements (levers 28) being constructed to be so small that they fit under the projection surface of the largest diameter of the mirror facets (11).

13. The device as claimed in claim 12, **characterized in that** the transmission elements are constructed as a lever (28).

14. The device as claimed in claim 12, 13 or 14, **characterized in that** the control means (27) act on the lever element (23) via spring means (29).

15. The device as claimed in claim 14, **characterized in that** three control means (27) act on the lever element (23) such that the actions of their forces (F₁, F₂, F₃) are at an angle of in each 120° to one another and at least approximately perpendicular to a longitudinal axis of the lever element (23) (which is in a neutral position).

16. The device as claimed in one of the claims 12 to 14, **characterized in that** two control means (27) act on the lever element (23) such that the actions of their forces (Fₓ, F_{y}) are at an angle of 90° to one another and at least approximately perpendicular to a longitudinal axis of the lever element (23) being pressed by a spring means (31) at an angle of in each case 135° to the actions of the forces (Fₓ, F_{y}) in the direction of the points of action thereof.

17. The device as claimed in one of claims 12 to 16, **characterized in that** the control means (A, 27) are constructed as setscrews.

18. The device as claimed in one of claims 12 to 16, **characterized in that** the control means (A, 27) are constructed as actuators.

19. The device as claimed in one of claims 12 to 16, **characterized in that** the control means can be moved in a direction at least approximately parallel to the lever element (23) aligned in the basic position, and act on the lever element (23) via a contact between a spherical surface and a conical surface.

20. The device as claimed in claim 19, **characterized in that** the control means are constructed as setscrews (33) that are of spherical construction in the region in which they are in contact with the lever element (23), the lever element (23) having in the contact region a cone (32) that tapers in the direction of the mirror.

21. The device as claimed in claim 19, **characterized in that** the control means are constructed as setscrews (33) that have in the region in which they are in contact with the lever element (23) a cone (34') that respectively tapers in the direction of the mirror, the lever element (23) being of spherical construction in the contact region.

## Revendications

1. Miroir à facettes (10) comportant plusieurs facettes de miroir (11), qui est utilisé dans des dispositifs d'éclairage (3) pour installations d'exposition par projection (1) dans la microlithographie, en particulier dans la microlithographie comportant l'utilisation d'un rayonnement situé dans la région de l'extrême ultraviolet, dans lequel au moins une partie des facettes de miroir (11) comporte à chaque fois un corps sphérique (17), dans lequel une surface de miroir (12) est disposée dans un évidement (18) du corps sphérique (17), le côté du corps sphérique (17) qui est éloigné de la surface de miroir (12) tournant dans un dispositif de portée (15), dans lequel un élément formant levier (23) est disposé sur au moins une partie des facettes de miroir (11), sur le côté du corps sphérique (17) qui est éloigné de la surface de miroir (12), l'élément formant levier (23) étant attaqué, dans une région éloignée du corps sphérique (17), par des moyens de réglage (A, 27) à l'aide desquels il est possible d'obtenir un mouvement du corps sphérique (17) autour de son centre, et dans lequel les moyens de réglage (27) attaquent l'élément formant levier (23) par l'intermédiaire d'éléments de mécanisme constitués par des leviers (28), les éléments de mécanisme (leviers 28) étant suffisamment petits pour se loger sous la surface de projection du plus grand diamètre des facettes de miroir (11).

2. Miroir à facettes selon la revendication 1, **caractérisé en ce que** l'élément formant levier (23) et le corps sphérique (17) sont d'un seul tenant.

3. Miroir à facettes selon la revendication 1 ou 2, **caractérisé en ce que** l'élément formant levier (23) est formé en alignement avec la normale (n) à la surface de miroir (12).

4. Miroir à facettes selon l'une des revendications 1 à 3, **caractérisé en ce que** la surface de miroir (12) est formée directement dans l'évidement du corps sphérique (17).

5. Miroir à facettes selon l'une des revendications 1 à 3, **caractérisé en ce que** la surface de miroir (12) est disposée sur un élément intermédiaire (13) fait d'un substrat qui est encastré dans l'évidement (18) du corps sphérique (17) et rélié à ce dernier.

6. Miroir à facettes selon la revendication 5, **caractérisé en ce que** l'élément intermédiaire (13) est accolé au corps sphérique (17) dans l'évidement (18) du corps sphérique (17).

7. Miroir à facettes selon l'une des revendications 1 à 6, **caractérisé en ce que** le dispositif de portée (15) a la forme d'une calotte de sphère (26) qui correspond en diamètre au diamètre du corps sphérique (17).

8. Miroir à facettes selon l'une des revendications 1 à 6, **caractérisé en ce que** le dispositif de portée est conformé de telle manière que le corps sphérique (17) forme avec le dispositif de portée (15) une surface d'appui (20) au moins approximativement annulaire.

9. Miroir sphérique selon la revendication 8, **caractérisé en ce que** le dispositif de portée (15) a la forme d'un perçage conique (19) ménagé dans une plaque porteuse (16) et qui s'ouvre en direction de la surface de miroir (12).

10. Miroir à facettes selon l'une des revendications 1 à 6, **caractérisé en ce que** le dispositif de portée est conformé de telle manière qu'avec le dispositif de portée (15), le corps sphérique (17) forme exactement trois surfaces d'appui (éléments d'appui 24) au moins approximativement ponctuelles.

11. Miroir à facettes selon l'une des revendications 1 à 10, **caractérisé en ce que** chacun des corps sphériques (17) est sollicité avec une force en direction du dispositif de portée par l'intermédiaire de moyens élastiques.

12. Dispositif (15) pour l'ajustement des facettes de miroir (11) d'un miroir à facettes (10) qui est utilisé dans des dispositifs d'éclairage (3) pour installations d'exposition par projection (1) dans la microlithographie, en particulier dans la microlithographie comportant l'utilisation d'un rayonnement situé dans la région de l'extrême ultraviolet, dans lequel chacune des facettes de miroir (11) est constituée par un corps sphérique (17), dans lequel une surface de miroir (12) est disposée dans un évidement (18) du corps sphérique (17), le côté du corps sphérique (17) qui est éloigné de la surface de miroir (12) tournant dans un dispositif de portée (15), dans lequel un élément formant levier (23) est disposé sur chacune des facettes de miroir (11), sur le côté du corps sphérique (17) qui est éloigné de la surface de miroir (12), dans lequel l'élément formant levier (23) est attaqué, dans une région éloignée du corps sphérique (17), par des moyens de réglage (A, 27) à l'aide desquels il est possible d'obtenir un mouvement du corps sphérique (17) autour de son centre, et dans lequel les moyens de réglage (27) attaquent l'élément formant levier (23) par l'intermédiaire d'éléments de mécanisme constitués par des leviers (28), les éléments de mécanisme (leviers 28) étant suffisamment petits pour se loger sous la surface de projection du plus grand diamètre des facettes de miroir (11).

13. Dispositif selon la revendication 12, **caractérisé en ce que** les éléments de mécanisme sont constitués par des leviers (28).

14. Dispositif selon la revendication 12, 13 ou 14, **caractérisé en ce que** les moyens de réglage (27) attaquent l'élément formant levier (23) par l'intermédiaire de moyens élastiques (29).

15. Dispositif selon la revendication 14, **caractérisé en ce que** trois moyens de réglage (27) attaquent l'élément formant levier (23) de telle manière que leurs lignes d'action de force (F₁, F₂, F₃) forment un angle de 120° entre elles et soient au moins approximativement perpendiculaires à un axe longitudinal de l'élément formant levier (23) (situé dans une position neutre).

16. Dispositif selon l'une des revendications 12 à 14, **caractérisé en ce que** deux moyens de réglage (27) attaquent l'élément formant levier (23) de telle manière que leurs effets dynamiques (Fₓ, F_{y}) forment un angle de 90° l'un par rapport à l'autre et soient au moins approximativement perpendiculaires à un axe longitudinal de l'élément formant levier (23) (situé dans une position neutre), l'élément formant levier (23) étant pressé contre les points d'attaque des effets dynamiques (Fₓ, F_{y}), par un élément élastique (31), en formant à chaque fois un angle de 135° avec ces effets.

17. Dispositif selon l'une des revendications 12 à 16, **caractérisé en ce que** les moyens de réglage (A, 27) sont constitués par des vis de réglage.

18. Dispositif selon l'une des revendications 12 à 16, **caractérisé en ce que** les moyens de réglage (A, 27) sont constitués par des actionneurs.

19. Dispositif selon l'une des revendications 12 à 16, **caractérisé en ce que** les moyens de réglage peuvent se déplacer dans une direction au moins à peu près parallèle à l'élément formant levier (23) orienté dans une position de base, et attaquent l'élément formant levier (23) par l'intermédiaire d'un contact entre une surface bombée et une surface conique.

20. Dispositif selon la revendication 19, **caractérisé en ce que** les moyens de réglage sont constitués par des vis de réglage (33) qui sont de forme bombée dans la région dans laquelle elles entrent en contact avec l'élément formant levier (23), l'élément formant levier (23) comportant, dans la région de contact, un cône (32) qui se rétrécit en direction du miroir.

21. Dispositif selon la revendication 19, **caractérisé en ce que** les moyens de réglage sont constitués par des vis de réglage (33) qui comportent, dans la région dans laquelle elles sont en contact avec l'élément formant levier (23), un cône (34') qui se rétrécit à chaque fois en direction du miroir, l'élément formant levier (23) étant de forme arrondie dans la région de contact.
